# EUROPEAN PATENT SPECIFICATION

(11) **EP 3 817 538 B1**
(45) Date of publication and mention of the grant of the patent: **06.09.2023**
(21) Application number: 18924389.2
(22) Date of filing: 26.06.2018
(51) Int. Cl.: H05K 13/02, H05K 13/04, B32B 38/10, B32B 43/00, B65H 20/20

(54) **FEEDER**
ZUFÜHRER
DISPOSITIF D'AVANCE

(43) Date of publication of application: 05.05.2021
(73) Proprietor: Fuji Corporation, Chiryu-shi, Aichi 472-8686 (JP)
(72) Inventor: OHASHI, Hiroyasu, Chiryu-shi, Aichi 472-8686 (JP); MURASE, Hiroki, Chiryu-shi, Aichi 472-8686 (JP)
(74) Representative: Grünecker Patent- und Rechtsanwälte PartG mbB
(86) International application number: PCT/JP2018/024245
(87) International publication number: WO 2020/003388

(56) References cited:
- EP-A1- 3 250 019
- WO-A1-2016/117091
- JP-A- 2005 503 677
- JP-A- 2011 029 260
- JP-A- 2014 053 601
- JP-A- 2014 078 607
- JP-A- 2015 103 664
- JP-U- S57 148 875

## Description

### Technical Field

The present specification relates to a feeder.

### Background Art

Conventionally, a feeder for subsequently supplying components such as electronic components to component supply positions in order to transfer the components to a board is known (for example, refer to Patent Literature 1). A carrier tape has a base tape provided with an accommodation section for accommodating the components, and a cover tape attached to an upper surface of the base tape to close the accommodation section. The feeder disclosed in Patent Literature 1 includes a tape conveyance path, a feeding device, and a tape guide. The tape conveyance path supports a lower surface of the carrier tape extending along a predetermined feeding direction in which the carrier tape is fed. The feeding device is a device including a sprocket for feeding the carrier tape on the tape conveyance path. The tape guide is a member that guides the carrier tape by restricting an upward movement of the carrier tape during conveyance to, and is provided above the tape conveyance path.

A peeling blade is provided to the tape guide on the way thereof in the predetermined feeding direction. Peeling blade is a blade member for peeling the cover tape from the base tape of the carrier tape. Peeling blade is formed to be substantially horizontal so that a cutting edge of a tip of peeling blade enters an attachment surface between the base tape and the cover tape. Peeling blade enters the attachment surface between the base tape and the cover tape during conveyance of the carrier tape, and separates the base tape and the cover tape upward and downward. After the cover tape is peeled off from the base tape by peeling blade, the feeder supplies the component inside the base tape from which the cover tape is peeled off to the component supply position so that the component can be fetched.

Further related background art is disclosed in Patent Literature 2, Patent Literature 3 and Patent Literature 4.

### Patent Literature

Patent Literature 1: JP-A-2011-211169
Patent Literature 2: EP 3 250 019 A1
Patent Literature 3: JP 2011 029260 A
Patent Literature 4: JP 2014 078607 A

### Summary of the Invention

### Technical Problem

Incidentally, in the feeder, from a peeling position, where the cover tape is peeled off from the base tape of the carrier tape by the peeling blade, to the component supply position, where the component inside the accommodation section of the base tape is fetched, the component having been inside the accommodation section is exposed outside without being covered by the cover tape. When the cover tape is peeled off, the base tape around the accommodation section after the cover tape is peeled off from a bottom surface of the peeling blade is pressed downward from above. Therefore, the bottom surface of the peeling blade is likely to hit the exposed component inside the accommodation section, thereby causing a possibility that the component may be damaged.

The present specification discloses a feeder capable of preventing a component exposed inside a base tape of a carrier tape from being damaged by a tape guide.

### Solution to Problem

The present specification discloses a feeder for supplying a component to a predetermined supply position by feeding a carrier tape accommodating the component in a predetermined feeding direction, in which the carrier tape has a base tape provided with an accommodation section for accommodating the component, and a cover tape attached to an upper surface of the base tape to close the accommodation section; the feeder includes a tape conveyance path extending along the predetermined feeding direction to support a lower surface of the carrier tape, a feeding device that feeds the carrier tape on the tape conveyance path, and a tape guide provided above the tape conveyance path to guide the carrier tape on the tape conveyance path; the tape guide has a peeling member that peels off the cover tape from the base tape of the carrier tape on the tape conveyance path, and an upper surface support portion, being provided on a downstream side of a tip portion of the peeling member in the predetermined feeding direction, which is configured to restrict an upward movement of the base tape, from which the cover tape is peeled off, by coming into contact with the upper surface of the base tape, and which has a lower surface positioned below a bottom surface of the tip portion of the peeling member, wherein the tape guide has a step portion formed between the bottom surface of the tip portion of the peeling member and the lower surface of the upper surface support portion.

According to the present disclosure, since the bottom surface of the tip portion of the peeling member is positioned above the lower surface of upper surface support portion on the downstream side of the tip portion in the feeding direction, a height position of a boundary area between the base tape and the cover tape at a peeling position of the carrier tape is higher than a height position of the upper surface of the base tape at a support position supported by the upper surface support portion. In this structure, the base tape from which the cover tape is peeled off at the peeling position is pulled downward in a range from the peeling position to the support position. Therefore, after the cover tape is peeled off from the base tape, since it is possible to avoid the component exposed inside the accommodation section of the base tape from being likely to come into contact with the lower surface of the tape guide including the peeling member, it is possible to prevent the component from being damaged by the tape guide.

### Brief Description of Drawings

[Fig. 1] Fig. 1 is a top view of a component mounter including a feeder according to an embodiment.
[Fig. 2] Fig. 2 is a top view of a carrier tape.
[Fig. 3] Fig. 3 is a sectional view taken along line III-III of the carrier tape illustrated in Fig. 2.
[Fig. 4] Fig. 4 is a perspective view on a side surface side of the feeder according to the embodiment.
[Fig. 5] Fig. 5 is an enlarged view of a rear part on the side surface side of the feeder according to the embodiment.
[Fig. 6] Fig. 6 is an enlarged view of the rear part on the side surface side of the feeder according to the embodiment in a state where an operation lever is lifted.
[Fig. 7] Fig. 7 is an enlarged view of the rear part on the side surface side of the feeder according to the embodiment in a state where the lifted operation lever is released and a carrier tape is conveyed.
[Fig. 8] Fig. 8 is a sectional view illustrating a disposition relationship among a tape guide, the carrier tape, and a sprocket in the feeder according to the embodiment.
[Fig. 9] Fig. 9 is a perspective view of a front section of the feeder according to the embodiment.
[Fig. 10] Fig. 10 is a top view illustrating a relationship between the tape guide and the carrier tape immediately before tape peeling starts in the feeder according to the embodiment.
[Fig. 11] Fig. 11 is a sectional view taken along line XI-XI illustrated in Fig. 10.
[Fig. 12] Fig. 12 is a sectional view taken along line XII-XII illustrated in Fig. 10.
[Fig. 13] Fig. 13 is a top view illustrating a relationship between the tape guide and the carrier tape immediately after the tape peeling starts in the feeder according to the embodiment.
[Fig. 14] Fig. 14 is a sectional view taken along line XIV-XIV illustrated in Fig. 13.
[Fig. 15] Fig. 15 is a sectional view taken along line XV-XV illustrated in Fig. 13.
[Fig. 16] Fig. 16 is a sectional view of a main section of a tape guide in a feeder according to a modification example.
[Fig. 17] Fig. 17 is a top view of a main section of a tape guide in a feeder of according to a modification example.
[Fig. 18] Fig. 18 is a top view of a main section of a tape guide in a feeder according to a modification example.

### Description of Embodiments

### 1. Configuration of Component Mounter Equipped with Feeder

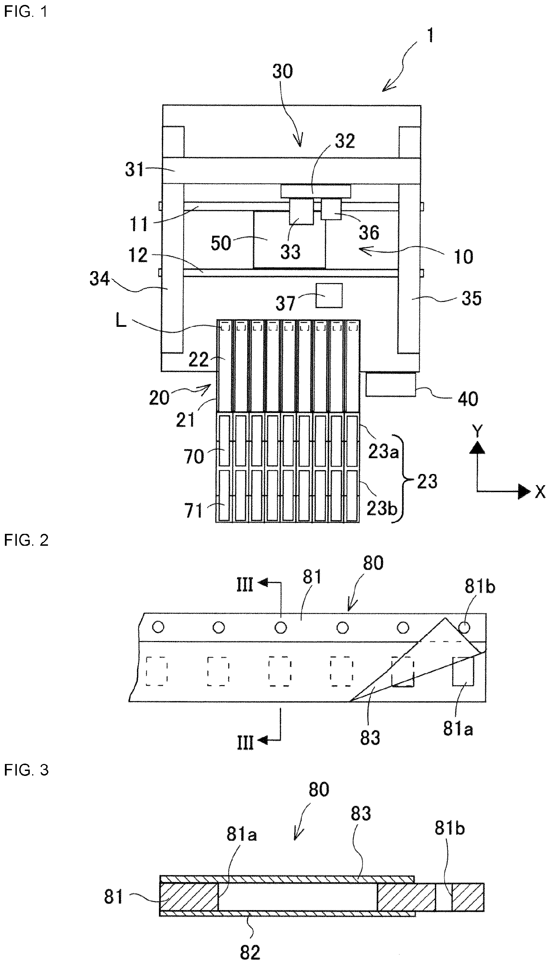

A configuration of component mounter 1 equipped with a feeder according to an embodiment will be described with reference to Figs. 1 to 3. The feeder according to the present embodiment is a device applicable to component mounter 1 provided on a board production line for mounting a component on a board. As illustrated in Fig. 1, component mounter 1 includes board conveyance section 10, component supply section 20, and component transfer section 30.

Board conveyance section 10 is a device that conveys board 50 such as a production target circuit board. Board conveyance section 10 has a pair of guide rails 11 and 12, a conveyor belt (not illustrated), and a clamping device (not illustrated). Guide rails 11 and 12 are installed on a base. The pair of guide rails 11 and 12 is disposed parallel to each other at an interval therebetween. Guide rails 11 and 12 guide board 50. The conveyor belt is a belt member on which board 50 can be placed, and is provided to be rotatable. The conveyor belt conveys board 50 placed thereon in conveyance direction X in which guide rails 11 and 12 extend. Board 50 is conveyed in conveyance direction X by the conveyor belt while being guided by the pair of guide rails 11 and 12. The clamping device is disposed so that board 50 is positioned at a predetermined component mounting position. Board 50 is positioned by the clamping device when conveyed to the predetermined component mounting position by the conveyor belt.

Component supply section 20 is a device that supplies component 60 to be mounted on board 50 to predetermined component supply position L. Component 60 may include a micro-component having 0201 size (0.2 mm x 0.1mm), for example. Component supply section 20 has slot 21, feeder 22, and reel holding section 23. Slot 21 is attached to a base. Slot 21 is disposed in direction Y orthogonal to conveyance direction X with respect to board conveyance section 10 (hereinafter, referred to as an orthogonal direction.). Slot 21 is a holding section on which feeder 22 is mounted to be attachable and detachable. Multiple slots 21 are aligned in conveyance direction X.

Reel holding section 23 can hold two reels 70 and 71 to be exchangeable and rotatable. Reel holding section 23 has a first holding section 23a corresponding to reel 70, and a second holding section 23b corresponding to reel 71. Reel holding section 23 is disposed in orthogonal direction Y with respect to feeder 22. First holding section 23a and second holding section 23b are disposed to be aligned in orthogonal direction Y. Corresponding to slot 21, that is, feeder 22, multiple reel holding section 23 are aligned in conveyance direction X. Each of reels 70 and 71 is a rotating body around which carrier tape 80 accommodating multiple components 60 are wound.

Carrier tape 80 is a tape member accommodating multiple components 60 in a row in a longitudinal direction. As illustrated in Figs. 2 and 3, carrier tape 80 has base tape 81, bottom tape 82, and cover tape 83. Base tape 81 is formed of a flexible material such as a paper material and a resin. Accommodation hole 81a is provided to penetrate base tape 81. Accommodation hole 81a is a hole for accommodating component 60. Accommodation holes 81a are provided at predetermined interval in the longitudinal direction of base tape 81.

In addition, engagement hole 81b is provided to penetrate base tape 81. Engagement hole 81b is a hole for engaging an engagement projection of a sprocket (to be described later). Engagement hole 81b is formed in a substantially circular shape or an elliptical shape. Engagement hole 81b has a size capable of engaging the engagement projection of the sprocket (to be described later). Engagement holes 81b are provided at a predetermined interval in the longitudinal direction of base tape 81.

Accommodation holes 81a are disposed in a row in the longitudinal direction on one side in a width direction of base tape 81, and engagement holes 81b are disposed in a row in the longitudinal direction on the other side in the width direction of base tape 81. An interval pitch of accommodation holes 81a in the longitudinal direction of base tape 81 corresponds in advance to an interval pitch of engagement holes 81b, and for example, the interval pitch of accommodation holes 81a is 1 time the interval pitch of engagement holes 81b.

Bottom tape 82 is attached and adhered to a lower surface (a portion provided with engagement hole 81b may be excluded) of base tape 81. Bottom tape 82 has a function of preventing component 60 from falling off by holding component 60 accommodated in accommodation hole 81a of base tape 81. Bottom tape 82 is formed of a transparent or translucent paper material, or a polymer film.

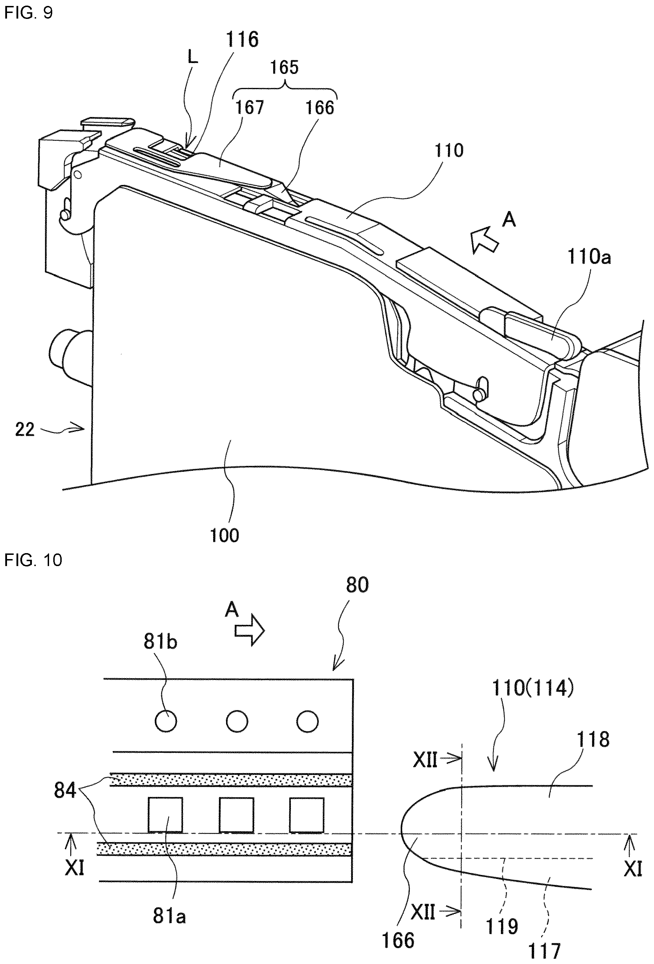

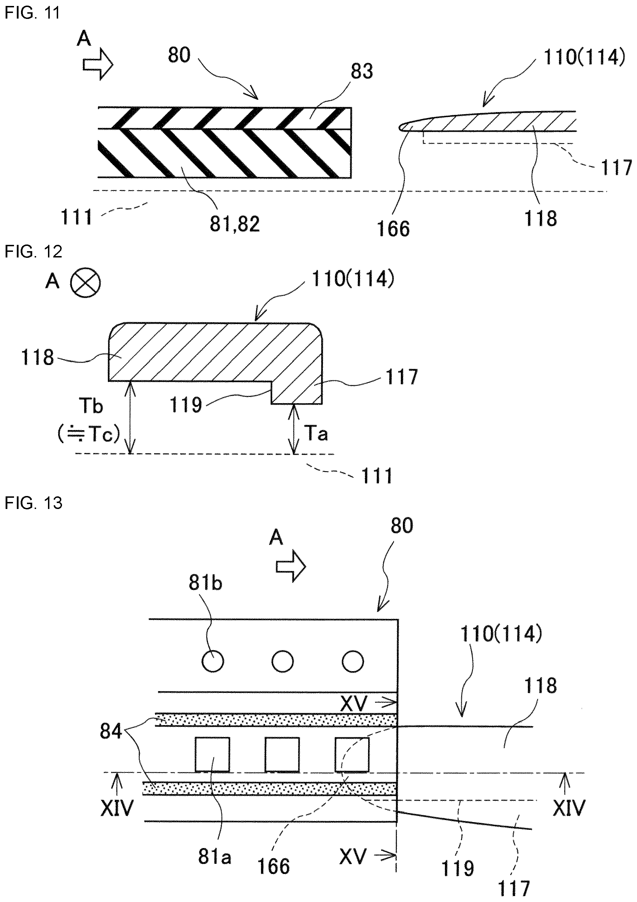

Cover tape 83 is attached and adhered to an upper surface (a portion provided with engagement hole 81b may be excluded) of base tape 81. Cover tape 83 has a function of preventing component 60 accommodated in accommodation hole 81a from thrusting out by closing an upper part of accommodation hole 81a of base tape 81. As illustrated in Figs. 10 and 13, two adhesion parts 84 to which base tape 81 and cover tape 83 are adhered respectively exist on both sides in the width direction with accommodation hole 81a of base tape 81 interposed therebetween, and each of adhesion parts 84 continuously extends in the longitudinal direction of carrier tape 80. The adhesion parts 84 may be scattered at a predetermined interval in the longitudinal direction of carrier tape 80. Cover tape 83 is formed of a transparent polymer film.

Feeder 22 is mounted on slot 21 to be attachable and detachable. Feeder 22 is a device that supplies component 60 accommodated in accommodation hole 81a of carrier tape 80 to predetermined component supply position L by feeding carrier tape 80 wound around reels 70 and 71 held by reel holding section 23 in orthogonal direction Y orthogonal to conveyance direction X of board 50. Details of feeder 22 will be described later.

Component transfer section 30 is a device that transfers component 60 supplied to predetermined component supply position L, from carrier tape 80 toward board 50 positioned at the predetermined component mounting position. The component transfer section 30 has Y-axis slider 31, X-axis slider 32, and mounting head 33.

Y-axis slider 31 is supported on the base by guide rails 34 and 35. Guide rails 34 and 35 extend in orthogonal direction Y orthogonal to conveyance direction X of board 50 conveyed by board conveyance section 10, and are disposed above board conveyance section 10. Y-axis slider 31 is movable in orthogonal direction Y along guide rails 34 and 35. A Y-axis servo motor (not illustrated) is mechanically coupled to Y-axis slider 31. Y-axis slider 31 is moved to a position in orthogonal direction Y by the Y-axis servo motor.

X-axis slider 32 is attached to Y-axis slider 31 to be movable in conveyance direction X. An X-axis servo motor (not illustrated) is mechanically coupled to X-axis slider 32 fixed to Y-axis slider 31. X-axis slider 32 is moved to a position in conveyance direction X by the X-axis servo motor.

Mounting head 33 is attached to X-axis slider 32. Mounting head 33 detachably holds a suction nozzle (not illustrated) capable of picking up the component 60. Mounting head 33 may be capable of holding multiple suction nozzles. Mounting head 33 is movable to a position in upward-downward direction Z orthogonal to both conveyance direction X and orthogonal direction Y. The suction nozzle of mounting head 33 uses a negative pressure to pick up component 60 supplied to predetermined component supply position L by component supply section 20, and mounts picked up component 60 on board 50 positioned at the predetermined component mounting position by releasing picked up component 60.

Board camera 36 is attached to X-axis slider 32. Board camera 36 images a reference mark of board 50 positioned at the predetermined component mounting position from above, and acquires board position reference information, or images component 60 supplied to predetermined component supply position L from above, and acquires component position information. The component position information is used for position control or posture control of the suction nozzle when component 60 is picked up by the suction nozzle of mounting head 33. In addition, the board position reference information is used for position control or posture control of the suction nozzle when component 60 picked up by the suction nozzle of mounting head 33 is mounted on board 50.

In addition, part camera37 is attached to the base of component transfer section 30. Part camera 37 images component 60 picked up by the suction nozzle of mounting head 33 from below, and acquires posture information of component 60. The posture information is used for position control or posture control of the suction nozzle when component 60 picked up by the suction nozzle of mounting head 33 is mounted on board 50.

### 2. Configuration of Feeder

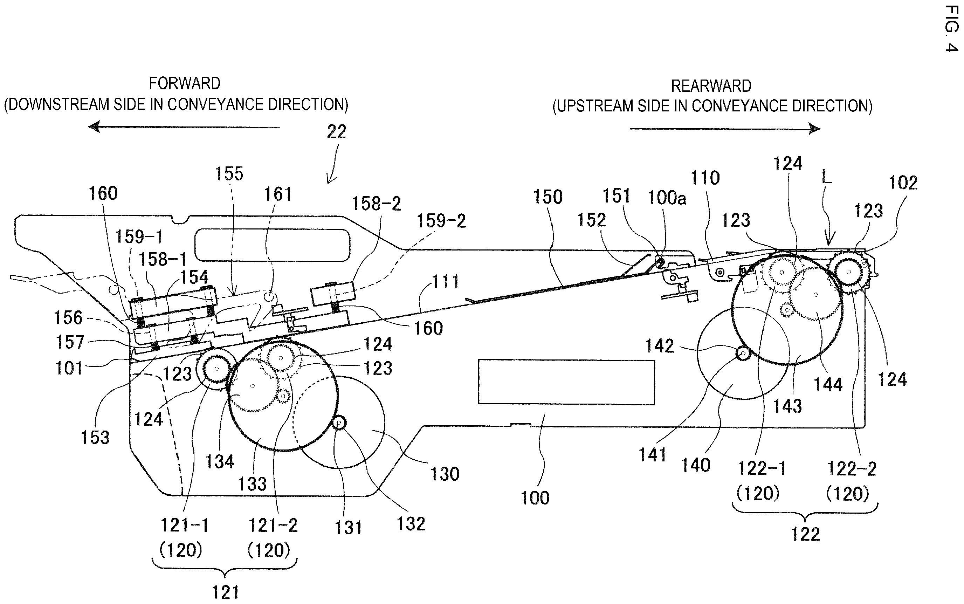

Next, a configuration of feeder 22 will be described with reference to Figs. 4 to 15. Feeder 22 feeds carrier tape 80 wound around reels 70 and 71 held in reel holding section 23 in orthogonal direction Y, and supplies component 60 accommodated in carrier tape 80 to predetermined component supply position L. As illustrated in Fig. 4, feeder 22 includes feeder main body 100 and sprocket 120.

Feeder main body 100 is formed in a flat box shape. Feeder main body 100 has tape insertion section 101 and tape discharge section 102. Tape insertion section 101 is an insertion port for inserting carrier tape 80. Tape insertion section 101 is provided in a rear part (that is, a section on a side opposite to board conveyance section 10 side) of feeder main body 100. Tape discharge section 102 is a discharge port for discharging carrier tape 80 outward. Tape discharge section 102 is provided in a front section (that is, a section on board conveyance section 10 side) of feeder main body 100.

Tape conveyance path 111 is provided in feeder main body 100. Tape conveyance path 111 is a rail extending along feeding direction A of carrier tape 80 between tape insertion section 101 and tape discharge section 102. Feeding direction A of carrier tape 80 coincides with orthogonal direction Y orthogonal to conveyance direction X of board 50 when feeder 22 is mounted on slot 21 of component supply section 20.

Tape conveyance path 111 guides carrier tape 80 during conveyance by supporting a lower surface thereof. Tape conveyance path 111 is formed to have a path width which is the same as a dimension in a width direction orthogonal to the longitudinal direction of carrier tape 80 or which is slightly larger than the dimension. Tape conveyance path 111 is inclined to be gradually higher from a rear part toward a front section. A foremost section of tape conveyance path 111 is horizontally formed.

Tape guide 110 is provided in feeder main body 100. Tape guide 110 is disposed above tape conveyance path 111. Tape guide 110 is a member that guides carrier tape 80 conveyed on tape conveyance path 111 between tape insertion section 101 and tape discharge section 102. Tape guide 110 is disposed above front side sprocket 122 (to be described later). Tape guide 110 guides carrier tape 80 so that a cutting edge of a tip of a peeling member (to be described later) is inserted between base tape 81 and cover tape 83 during conveyance of carrier tape 80, and guides base tape 81 in which component 60 is accommodated after cover tape 83 is peeled off, to component supply position L. Tape guide 110 is formed so that a cross-sectional shape is inverted U-shape which is open downward. Tape guide 110 may be separately attached to feeder main body 100, or may be provided integrally with feeder main body 100.

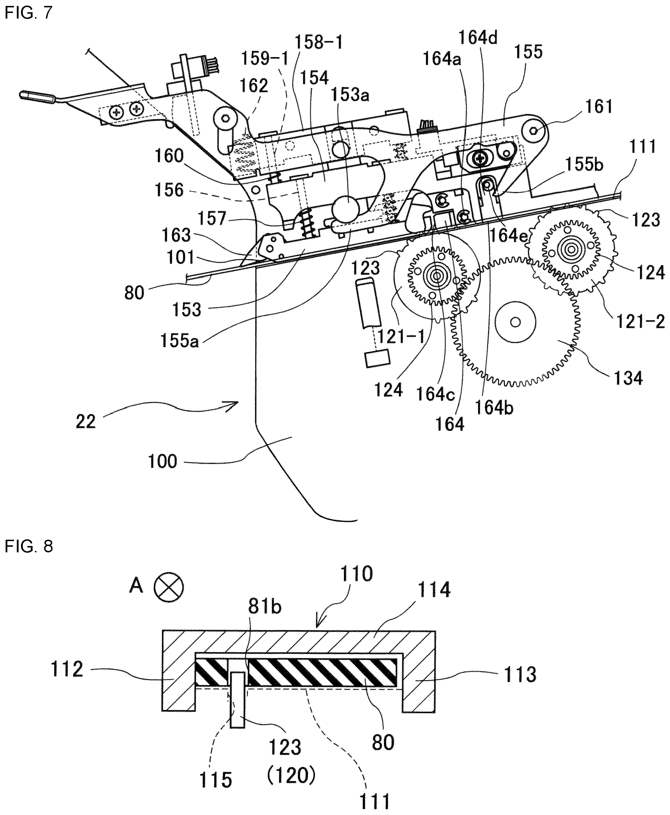

As illustrated in Fig. 8, tape guide 110 has a pair of guide side walls 112 and 113, and guide upper wall 114. Each of guide side walls 112 and 113 is a wall surface erected in the upward-downward direction and extending along feeding direction A of carrier tape 80. Guide side walls 112 and 113 have a role of guiding carrier tape 80 during conveyance in the width direction by restricting the movement of carrier tape 80 (specifically, carrier tape 80 engaging with front side sprocket 122) on tape conveyance path 111 in the width direction.

Guide side wall 112 is a side wall facing a side surface on which engagement hole 81b is disposed out of side surfaces in the width direction of carrier tape 80 on tape conveyance path 111. In addition, guide side wall 113 is a side wall facing a side surface on which accommodation hole 81a is disposed out of side surfaces in the width direction of carrier tape 80 on tape conveyance path 111. Guide side wall 112 and guide side wall 113 are disposed to face each other in parallel by interposing tape conveyance path 111 therebetween in the width direction, are separated from each other by the path width of tape conveyance path 111 in a direction (that is, conveyance direction X of board 50) orthogonal to feeding direction A.

Guide upper wall 114 is provided above tape conveyance path 111. Guide upper wall 114 is a wall surface horizontally widened to connect upper ends of the pair of guide side walls 112 and 113 to each other, and extending along feeding direction A of carrier tape 80. A front side of feeder 22 of guide upper wall 114 has a role of guiding carrier tape 80 upward during conveyance by restricting an upward movement of carrier tape 80 (specifically, carrier tape 80 engaging with front side sprocket 122) on tape conveyance path 111.

Sprocket 120 is a disc-shaped member provided below tape conveyance path 111 in feeder main body 100. Sprocket 120 is a rotating body that rotates in a direction (that is, a forward direction) in which carrier tape 80 on tape conveyance path 111 is conveyed toward tape discharge section 102 side from tape insertion section 101 side. Sprocket 120 may be capable of rotating in a direction (that is, a reverse direction) in which carrier tape 80 is conveyed toward tape insertion section 101 side from tape discharge section 102 side.

Sprocket 120 has rear side sprocket 121 and front side sprocket 122. Rear side sprocket 121 is rotatably attached to a rear side of tape conveyance path 111 in feeder main body 100. Rear side sprocket 121 rotates forward to feed carrier tape 80 inserted into tape insertion section 101 along tape conveyance path 111 toward tape discharge section 102 side. In addition, front side sprocket 122 is rotatably attached to a front side of tape conveyance path 111 in feeder main body 100. Front side sprocket 122 rotates forward to feed carrier tape 80 conveyed along tape conveyance path 111 from tape insertion section 101 side toward tape discharge section 102 side, and further feeds carrier tape 80 outward from tape discharge section 102.

Two rear side sprocket 121 are provided along tape conveyance path 111. Hereinafter, as appropriate, rear side sprocket 121 on an upstream side (that is, a rear side) will be referred to as first rear side sprocket 121-1, and rear side sprocket 121 on a downstream side (that is, a front side) will be referred to as second rear side sprocket 121-2, respectively. First rear side sprocket 121-1 and second rear side sprocket 121-2 rotate in synchronization with each other in the same rotation direction.

Two front side sprocket 122 are provided along tape conveyance path 111. Hereinafter, as appropriate, front side sprocket 122 on the upstream side (that is, the rear side) will be referred to as first front side sprocket 122-1, and front side sprocket 122 on the downstream side (that is, the front side) will be referred to as second front side sprocket 122-2, respectively. First front side sprocket 122-1 and second front side sprocket 122-2 rotate in synchronization with each other in the same rotation direction.

Each sprocket 120 (specifically, sprockets 121-1, 121-2, 122-1, and 122-2) has engagement projection 123. Engagement projection 123 is an outer tooth projecting outward in a radial direction in an outer periphery of sprocket 120. Engagement projection 123 of second rear side sprocket 121-2, engagement projection 123 of first front side sprocket 122-1, and engagement projection 123 of second front side sprocket 122-2 are respectively provided at each predetermined angle over the entire outer periphery. On the other hand, engagement projection 123 of first rear side sprocket 121-1 is provided in a portion of the outer periphery. That is, first rear side sprocket 121-1 has a portion where engagement projection 123 is not provided in the outer periphery.

A part positioned above each sprocket 120 in tape conveyance path 111 is provided with window hole 115. Each sprocket 120 is disposed so that engagement projection 123, being near an upper end, projects on tape conveyance path 111 through window hole 115. Engagement projection 123 can engage with engagement hole 81b of carrier tape 80 in a state of projecting on tape conveyance path 111.

Engagement projection 123 is formed so that a cross-sectional shape is substantially rectangular, and is formed so that a width in the circumferential direction gradually decreases outward in the radial direction from the inner side in the radial direction, that is, so that engagement projection 123 has a trapezoidal shape in a side view. Engagement projection 123 has a size which enables engagement hole 81b of carrier tape 80 to engage therewith. Engagement projection 123 is formed to engage with engagement hole 81b of carrier tape 80 in a state where a projection center coincides with a hole center.

Each sprocket 120 has gear 124. Gear 124 is formed on an inner diameter side from the outer periphery where engagement projection 123 of sprocket 120 is provided. Gear 124 is accommodated below tape conveyance path 111 without projecting on tape conveyance path 111 from window hole 115.

Feeder 22 includes rear side motor 130 attached to the rear side of feeder main body 100. Rear side motor 130 is a servo motor that rotates rear side sprocket 121, that is, first rear side sprocket 121-1 and second rear side sprocket 121-2. Rear side motor 130 can rotate rear side sprockets 121-1 and 121-2 in the forward direction. Rear side motor 130 may be capable of rotating rear side sprockets 121-1 and 121-2 in the reverse direction.

Rotary shaft 131 of rear side motor 130 is provided with drive gear 132. Drive gear 132 meshes with gear 124 of rear side sprockets 121-1 and 121-2 via two gears 133 and 134 rotatably attached to feeder main body 100. In this configuration, when rear side motor 130 is rotated, the rotation is transmitted to first rear side sprocket 121-1 and second rear side sprocket 121-2 while being decelerated by using gears 133 and 134, and rear side sprockets 121-1 and 121-2 rotate in synchronization with each other.

Feeder 22 includes front side motor 140 attached to the front side of feeder main body 100. Front side motor 140 is a servo motor that rotates front side sprocket 122, that is, first front side sprocket 122-1 and second front side sprocket 122-2. Front side motor 140 can rotate front side sprockets 122-1 and 122-2 in the forward direction. Front side motor 140 may be capable of rotating front side sprocket 122-1 and 122-2 in the reverse direction.

Rotary shaft 141 of front side motor 140 is provided with drive gear 142. Drive gear 142 meshes with gear 124 of front side sprockets 122-1 and 122-2 via two gears 143 and144 rotatably attached to feeder main body 100. In this configuration, when front side motor 140 is rotated, the rotation is transmitted to first front side sprocket 122-1 and second front side sprocket 122-2 while being decelerated by using gears 143 and 144, and front side sprockets 122-1 and 122-2 rotate in synchronization with each other.

Feeder 22 includes upper surface pressing member 150. Upper surface pressing member 150 is disposed above tape conveyance path 111, and is formed to be along and parallel to tape conveyance path 111 between second rear side sprocket 121-2 and first front side sprocket 122-1. A front end part of upper surface pressing member 150 has shaft support portion 151. Shaft support portion 151 is pivotally supported by a shaft portion provided in feeder main body 100. Upper surface pressing member 150 is attached to feeder main body 100 to be capable of oscillating in shaft support portion 151. Upper surface pressing member 150 is biased downward by biasing member 152 such as a torsion spring. Upper surface pressing member 150 has a function of preventing floating of carrier tape 80 by pressing the upper surface of carrier tape 80 conveyed along tape conveyance path 111, when upper surface pressing member 150 is biased downward by biasing member 152.

Feeder 22 includes inlet pressing member 153, downstream side pressing member 154, and operation lever 155. Inlet pressing member 153 is disposed close to tape insertion section 101 above tape conveyance path 111, and is formed to be along and parallel to the rear part of tape conveyance path 111. Downstream side pressing member 154 is disposed on the front side (downstream side) with respect to inlet pressing member 153 above tape conveyance path 111. Inlet pressing member 153 and downstream side pressing member 154 are respectively provided to be movable close to and away from tape conveyance path 111.

Inlet pressing member 153 is disposed below the rear part of downstream side pressing member 154, and is attached to the rear part of downstream side pressing member 154 via a pair of shafts 156. Spring 157 for biasing inlet pressing member 153 downward is attached to the pair of shafts 156. Inlet pressing member 153 has a function of pressing carrier tape 80 to be inserted into tape insertion section 101 toward tape conveyance path 111 when inlet pressing member 153 is biased downward by spring 157. Downstream side pressing member 154 is attached to support members 158-1 and 158-2 attached to feeder main body 100 via the pair of shafts 159-1 and 159-2. Spring 160 for biasing downstream side pressing member 154 downward is attached to shafts 159-1 and 159-2. Downstream side pressing member 154 has a function of pressing carrier tape 80 on the downstream side of inlet pressing member 153 toward tape conveyance path 111, when downstream side pressing member 154 is biased downward by spring 160.

Operation lever 155 is provided to project rearward above the position of tape insertion section 101 of feeder main body 100. Operation lever 155 is supported by the rear part of feeder main body 100 to be pivotable around pivot 161. Operation lever 155 is operated to pivot around pivot 161 by an operator.

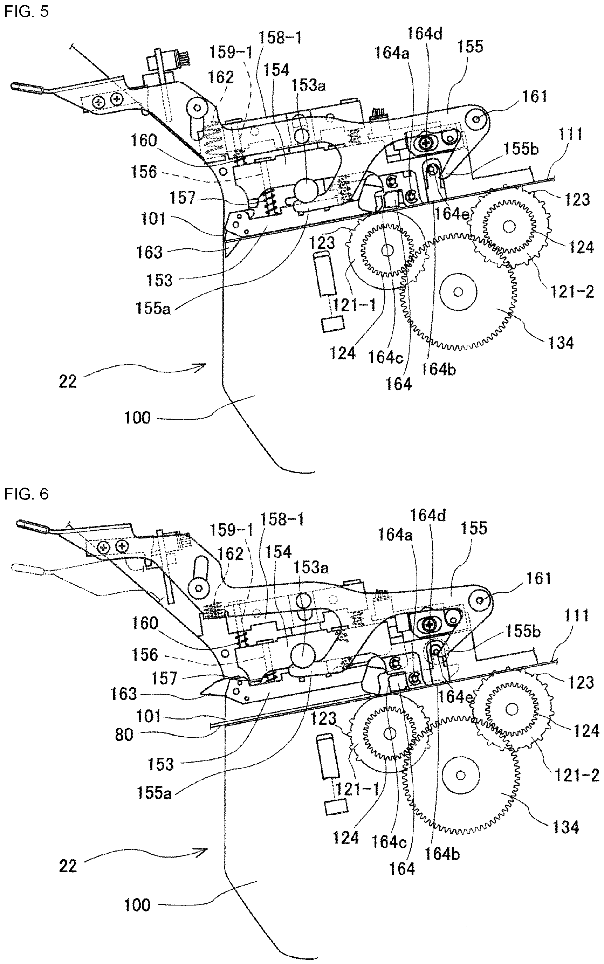

Inlet pressing member 153 is coupled to operation lever 155 to be operable. Inlet pressing member 153 has engagement member 153a disposed between the pair of shafts 156. Operation engagement portion 155a is provided in a front and rear central part of operation lever 155. Operation engagement portion 155a engages with the lower surface of engagement member 153a of inlet pressing member 153. Operation lever 155 is caused to pivot in a predetermined pivoting direction (counterclockwise in Fig. 5) by the biasing force of spring 162. In a normal state where a force against the biasing force of spring 162 (that is, a force acting in a direction (clockwise in Fig. 5) opposite to the pivoting direction of the biasing force) is not applied to operation lever 155, operation engagement portion 155a is held at a predetermined lower end position as illustrated in Fig. 5, and inlet pressing member 153 is pressed toward tape conveyance path 111 by the biasing force of spring 157, and accordingly, new carrier tape 80 cannot be inserted into tape insertion section 101.

On the other hand, as illustrated in Fig. 6, when operation lever 155 is lifted upward by an operator and is caused to pivot around pivot 161 against the biasing force of spring 162, operation engagement portion 155a is raised, and inlet pressing member 153 is raised against the biasing force of spring 157. Therefore, when the operator lifts operation lever 155, inlet pressing member 153 is separated from tape conveyance path 111, and accordingly, new carrier tape 80 can be inserted into tape insertion section 101.

Baffle plate 163 is pivotally supported by the rear part of inlet pressing member 153. Baffle plate 163 has a function of disabling the insertion of new carrier tape 80 by closing tape insertion section 101 by using its own weight in a state where inlet pressing member 153 is pressed toward tape conveyance path 111. Baffle plate 163 is rotated by engaging with the rear part of downstream side pressing member 154 when inlet pressing member 153 is raised, and opens tape insertion section 101 so that new carrier tape 80 can be inserted.

Stopper member 164 is provided adjacent to the downstream side of inlet pressing member 153. Stopper member 164 is supported by downstream side pressing member 154 to be pivotable in shaft support portion 164a provided in a central part thereof. Stopper member 164 is provided with contact portion 164b. Contact portion 164b is provided in a forward lower section of stopper member 164 from shaft support portion 164a. Contact portion 164b can come into contact with tape conveyance path 111 by projecting downward. Contact portion 164b is biased in a direction for coming into contact with tape conveyance path 111 by a spring (not illustrated) provided between downstream side pressing member 154 and stopper member 164.

Stopping portion 164c is provided in a rear end part of stopper member 164. Stopping portion 164c is provided to be closeable to and separable from tape conveyance path 111. Stopping portion 164c has a bottom surface with which a tip of carrier tape 80 can come into contact, and has a function of preventing carrier tape 80 from being conveyed to the downstream side when coming into contact with tape conveyance path 111. Stopping portion 164c is disposed at a boundary position which determines whether engagement hole 81b of carrier tape 80 whose tip is in contact the bottom surface of stopping portion 164c engages with engagement projection 123 of first rear side sprocket 121-1. This engagement is realized in a state where stopping portion 164c is separated from tape conveyance path 111.

Stopper member 164 is provided with protruding portion 164d. Protruding portion 164d is provided in a forward upper part of stopper member 164 from shaft support portion 164a. Protruding portion 164d protrudes upward. Cam follower 164e is provided in a tip of the protruding portion 164d. Cam portion 155b is formed in a front part of operation lever 155. Cam portion 155b is capable of engaging with and disengaging from cam follower 164e.

As illustrated in Fig. 5, operation lever 155 pivots in a predetermined pivot direction due to a biasing force of spring 162, and in a state where inlet pressing member 153 is held at a position for coming into contact with tape conveyance path 111, cam portion 155b of operation lever 155 is separated from cam follower 164e of stopper member 164. In this case, stopper member 164 pivots around shaft support portion 164a in an opposite direction due to a biasing force of a spring (not illustrated), contact portion 164b is brought into contact with tape conveyance path 111, and is held in a state where stopping portion 164c is separated from tape conveyance path 111.

On the other hand, as illustrated in Fig. 6, when operation lever 155 pivots against the biasing force of spring 162, cam portion 155b of operation lever 155 engages with cam follower 164e of stopper member 164. In this case, stopper member 164 pivots around shaft support portion 164a in the predetermined pivot direction against the biasing force of the spring (not illustrated), and stopping portion 164c is brought into contact with tape conveyance path 111. When carrier tape 80 is inserted into tape insertion section 101 in this state, inserted carrier tape 80 enters between the tape upper surface biasing member and the tape lower surface biasing member in feeder main body 100, and thereafter, a tip thereof is stopped by coming into contact with stopping portion 164c of stopper member 164.

After carrier tape 80 (hereinafter, carrier tape80 in this case will be referred to as former carrier tape 80) passes between tape conveyance path 111 and contact portion 164b of stopper member 164, contact portion 164b is lifted by former carrier tape 80, and stopping portion 164c of stopper member 164 comes into contact with tape conveyance path 111. In this state, when new carrier tape 80 (hereinafter, carrier tape 80 in this case will be referred to as new carrier tape 80) is inserted into tape insertion section 101 and is overlapped on former carrier tape 80, new carrier tape 80 enters between the tape upper surface biasing member and the tape lower surface biasing member, and thereafter, a tip of new carrier tape 80 is stopped by coming into contact with stopping portion 164c of stopper member 164. In this manner, when former carrier tape 80 is conveyed on tape conveyance path 111, the conveyance to the downstream side of new carrier tape 80 is prevented, and new carrier tape 80 waits at that position.

Feeder 22 includes tape peeling device 165. As illustrated in Fig. 9, tape peeling device 165 is disposed on a front side upper part of feeder main body 100. Tape peeling device 165 is provided in tape guide 110. That is, tape guide 110 has tape peeling device 165. Tape peeling device 165 has peeling member 166 and folding member 167.

A biasing member (not illustrated) for biasing tape guide 110 downward is incorporated between tape guide 110 and feeder main body 100. Tape guide 110 is biased downward to be closer to feeder main body 100 by the biasing member. Lever 110a projects from a rear end part of tape guide 110. Lever 110a is a member for lifting tape guide 110 upward by an operator's lifting operation against the biasing force of the biasing member. In a case where lever 110a is not lifted, when carrier tape 80 does not enter tape guide 110, tape guide 110 is in contact with an upper surface of tape conveyance path 111 by the biasing force of the biasing member, and when carrier tape 80 enters tape guide 110, tape guide 110 holds and interposes carrier tape 80 between the upper surface of tape conveyance path 111 and sprocket 122 by the biasing force of the biasing member. On the other hand, when lever 110a is lifted against the biasing force of the biasing member, tape guide 110 is separated from upper surface of tape conveyance path 111 and sprocket 122, and releases carrier tape 80 held therebetween.

Peeling member 166 is disposed on an upstream side in predetermined feeding direction with respect to component supply position L, and for example, is disposed on a downstream side in the predetermined feeding direction of first front side sprocket 122-1 and on the upstream side in the predetermined feeding direction of second front side sprocket 122-2. Peeling member 166 is a blade member for peeling off cover tape 83 from base tape 81 of carrier tape 80 to bring component 60 into a state where component 60 can be fetched (picked up or transferred) from accommodation hole 81a at component supply position L.

Peeling member 166 is substantially horizontally formed so that a cutting edge of the tip of peeling member 166 is inserted between base tape 81 and cover tape 83 during the conveyance of carrier tape 80. As illustrated in Fig. 10, a tip portion of peeling member 166 is curved in a mount shape in a tape width direction so that the cutting edge of the tip projects in a direction opposite to feeding direction A of carrier tape 80.

Peeling member 166 is disposed to be biased in one of the width direction to peel off only one place on both sides (two places) in the width direction across accommodation hole 81a in which base tape 81 and cover tape 83 adhere to each other. The tip of peeling member 166 may be formed at a position in the width direction which corresponds to one place of two place adhesion parts between base tape 81 and cover tape 83. Therefore, when cover tape 83 is peeled off from base tape 81 by peeling member 166, whereas cover tape 83 is peeled off from base tape 81 on one end side in the width direction, cover tape 83 is in a state of adhering to base tape 81 on the other end side.

Folding member 167 is disposed on the downstream side in the predetermined feeding direction with respect to peeling member 166 (that is, peeling position where cover tape 83 is peeled off from base tape 81 by peeling member 166), and is disposed on the upstream side in the predetermined feeding direction with respect to component supply position L. Folding member 167 is a member for erecting and folding one end side in the width direction of peeled cover tape 83 (specifically, an end side on which accommodation hole 81a for accommodating component 60 is disposed out of both ends in the width direction of carrier tape 80). Folding member 167 is formed in a plate shape which is substantially horizontally widened.

Guide upper wall 114, is provided with component fetching section 116. Component fetching section 116, is a hole section which is open on guide upper wall 114 and is capable of fetching component 60 accommodated in accommodation hole 81a of base tape 81. A position where component fetching section 116 open on guide upper wall 114 is provided is located on the downstream side in predetermined feeding direction from the above-described peeling position, and is predetermined component supply position L of feeder 22. Component fetching section 116 is formed to have a size that does not come into contact with guide upper wall 114 when the suction nozzle for picking up and holding component 60 in component transfer section 30 transfers component 60. A part passing through component fetching section 116 in carrier tape 80 hangs downward from a front part of feeder 22, and is discharged outward from feeder 22.

### 3. Operation of Feeder

In feeder 22, former carrier tape 80 is wound around reel 70 held by first holding section 23a, and new carrier tape 80 is wound around reel 71 is held by second holding section 23b. In a normal state where operation lever 155 is held by the biasing force of spring 162, as illustrated in Fig. 5, inlet pressing member 153 is held at a position which comes into contact with tape conveyance path 111, and baffle plate 163 pivots due to its own weight, thereby closing tape conveyance path 111.

When operation lever 155 is operated to be lifted against the biasing force of spring 162 in the above-described state, as illustrated in Fig. 6, inlet pressing member 153 is raised against the biasing force of spring 157 since operation engagement portion 155a is raised. In this case, inlet pressing member 153 is separated from tape conveyance path 111, and baffle plate 163 is caused to pivot by downstream side pressing member 154, thereby opening tape insertion section 101 to be brought into a state where carrier tape 80 can be inserted. At the same time, stopper member 164 is caused to pivot by cam portion 155b of operation lever 155, and stopping portion 164c comes into contact with tape conveyance path 111.

In this state, when former carrier tape 80 is inserted from tape insertion section 101 onto tape conveyance path 111 by an operator, the tip of former carrier tape 80 can be inserted to a position which comes into contact with stopping portion 164c of stopper member 164. When a lifting operation of operation lever 155 is released in a state where former carrier tape 80 is inserted to the position which comes into contact with stopping portion 164c, operation lever 155 is caused to pivot by the biasing force of spring 162, and returns to an original position. In this original point return state, as illustrated in Fig. 7, inlet pressing member 153 is lowered toward tape conveyance path 111 by the biasing force of spring 157 so that former carrier tape 80 is pressed toward tape conveyance path 111 and baffle plate 163 closes tape insertion section 101 by its own weight. At the same time, stopper member 164 brings contact portion 164b into contact with tape conveyance path 111 by the biasing force of the spring, and separates stopping portion 164c from tape conveyance path 111.

When the insertion of former carrier tape 80 into tape insertion section 101 is detected by using various sensors, the presence of former carrier tape 80 on tape conveyance path 111 is detected, and it is detected that operation lever 155 returns to the original position, rear side motor 130 is driven so that first and second rear side sprockets 121-1 and 121-2 rotate in the forward direction. When rear side motor 130 is driven, first and second rear side sprockets 121-1 and 121-2 are rotated in the forward direction.

In this case, first, while the tip side of former carrier tape 80 is allowed to be conveyed from stopping portion 164c to the downstream side in the predetermined feeding direction by separation of stopping portion 164c from tape conveyance path 111, first rear side sprocket 121-1 rotates forward in a state where engagement projection 123 engages with engagement hole 81b of former carrier tape 80 so that former carrier tape 80 is conveyed to tape discharge section 102 side by the forward rotation of first rear side sprocket 121-1. When conveyed in this way, downstream side pressing member 154 is lifted against the biasing force of spring 160 by former carrier tape 80, and former carrier tape 80 is conveyed between downstream side pressing member 154 and tape conveyance path 111.

As described above, engagement projection 123 of first rear side sprocket 121-1 is provided only in a part of the outer periphery of first rear side sprocket 121-1. Therefore, after engagement projection 123 engages with engagement hole 81b of former carrier tape 80, former carrier tape 80 is intermittently fed toward tape discharge section 102 side. Therefore, carrier tape 80 is avoided from being rapidly pulled by first rear side sprocket 121-1. When downstream side pressing member 154 is lifted, shaft support portion 164a of stopper member 164 is integrally raised.

When former carrier tape 80 is progressively conveyed by the forward rotation of first rear side sprocket 121-1, engagement projection 123 of second rear side sprocket 121-2 engages with engagement hole 81b on the tip side of former carrier tape 80. After the engagement, former carrier tape 80 is conveyed to tape discharge section 102 side by the forward rotation of second rear side sprocket 121-2. As described above, engagement projection 123 of second rear side sprocket 121-2 is provided over an entire outer periphery of second rear side sprocket 121-2. Therefore, after engagement projection 123 of second rear side sprocket 121-2 engages with engagement hole 81b of former carrier tape 80, former carrier tape 80 is moved to tape discharge section 102 in a short time.

When former carrier tape 80 is conveyed by the forward rotation of second rear side sprocket 121-2, first, the tip of former carrier tape 80 enters a part below upper surface pressing member 150 from between a guide section formed in a rear end part of upper surface pressing member 150 and tape conveyance path 111. Therefore, the tip side of former carrier tape 80 is conveyed toward front side sprocket 122 side in a state where floating from tape conveyance path 111 is suppressed by upper surface pressing member 150.

When it is detected by using the sensor that the tip of former carrier tape 80 has reached to the upstream side in the predetermined feeding direction with respect to first front side sprocket 122-1 as former carrier tape 80 is progressively conveyed by the forward rotation of second rear side sprocket 121-2, rear side motor 130 and front side motor 140 are driven so that first and second rear side sprockets 121-1 and 121-2 and first and second front side sprockets 122-1 and 122-2 intermittently rotate in the forward direction. When rear side motor 130 and front side motor 140 are driven, each rear side sprocket 121 and each front side sprocket 122 are intermittently rotated in the forward direction. An angle per operation of the intermittent rotation is set to a pitch interval of component 60 accommodated in carrier tape 80.

When engagement projection 123 of first front side sprocket 122-1 engages with engagement hole 81b of former carrier tape 80 in this state, former carrier tape 80 is conveyed to tape discharge section 102 side by the forward rotation of first front side sprocket 122-1, and cover tape 83 is peeled from former carrier tape 80 by tape peeling device 165 during the conveyance. When engagement projection 123 of second front side sprocket 122-2 engages with engagement hole 81b of former carrier tape 80, former carrier tape 80 is conveyed to tape discharge section 102 side by the forward rotation of second front side sprocket 122-2. Each time the rotation is stopped during the intermittent rotation of rear side sprocket 121 and front side sprocket 122, component 60 accommodated in former carrier tape 80 is positioned at component supply position L, and is transferred by component transfer section 30.

In addition, during the conveyance of former carrier tape 80 on tape conveyance path 111, former carrier tape 80 presses and lifts contact portion 164b of stopper member 164 so that stopper member 164 pivots around shaft support portion 164a against the biasing force of the spring. In this manner, stopping portion 164c of stopper member 164 comes into contact with the upper surface of former carrier tape 80.

In this state, when operation lever 155 is lifted and pivots against the biasing force of spring 162, since inlet pressing member 153 is separated from tape conveyance path 111, and baffle plate 163 opens tape insertion section 101, new carrier tape 80 can be inserted. When the tip side of new carrier tape 80 is inserted between former carrier tape 80 and inlet pressing member 153 through tape insertion section 101, the tip of new carrier tape 80 comes into contact with stopping portion 164c of stopper member 164 after entering between the tape upper surface biasing member and the tape lower surface biasing member, and the conveyance of new carrier tape 80 is stopped at that position. Therefore, the conveyance of new carrier tape 80 to the downstream side is blocked.

As described above, when the lifting operation of operation lever 155 is released in a state where new carrier tape 80 is inserted into a position which comes into contact with stopping portion 164c, operation lever 155 is caused to pivot by the biasing force of spring 162, and returns to the original position. At this time, since new carrier tape 80 lifts contact portion 164b of stopper member 164, stopping portion 164c of stopper member 164 maintains the stopping of new carrier tape 80.

As described above, in a state where the stopping of new carrier tape 80 is maintained, when a terminal end which is a rear end of former carrier tape 80 is conveyed to the downstream side in the predetermined feeding direction earlier than the tip which is a front end of new carrier tape 80, new carrier tape 80 comes into contact with the upper surface of tape conveyance path 111 located on the upstream side in the predetermined feeding direction with respect to former carrier tape 80, and engagement projection 123 of first rear side sprocket 121-1 engages with engagement hole 81b of new carrier tape 80. Then, first front side sprocket 122-1 rotates forward so that new carrier tape 80 enters a gap formed between tape conveyance path 111 and stopper member 164 by the presence of former carrier tape 80, and new carrier tape 80 is conveyed toward tape discharge section 102 side. When the tip of new carrier tape 80 lifts contact portion 164b, as described above, stopper member 164 pivots against the biasing force of the spring, and stopping portion 164c blocks the entrance of new carrier tape 80.

In this way, if two carrier tapes 80 are inserted into tape conveyance path 111, when first carrier tape 80 is completely conveyed, second carrier tape 80 can start to be conveyed. Therefore, two carrier tapes 80 are not conveyed from stopping portion 164c to the downstream side in the predetermined feeding direction in an overlapped state, and two carrier tapes 80 can be conveyed continuously in time so that component 60 accommodated in carrier tape 80 can be continuously supplied to component supply position L without any interruption. In addition, since both rear side motor 130 and front side motor 140 are driven so that each sprocket 120 rotates forward, component 60 accommodated in carrier tape 80 can be supplied to predetermined component supply position L.

### 4. Structure and Operational Effect of Tape Guide of Feeder

In feeder 22, feeder main body 100 includes tape guide 110 having a pair of guide side walls 112 and 113, guide upper wall 114, and tape peeling device 165. As described above, in tape guide 110, guide upper wall 114 is provided above tape conveyance path 111. A front side of feeder 22 of guide upper wall 114 has a role to restrict upward movement of carrier tape 80 by coming into contact with the upper surface of carrier tape 80 on tape conveyance path 111.

As illustrated in Figs. 10, 11, and 12, guide upper wall 114 has upper surface support portion 117. Upper surface support portion 117 is provided on the front side of feeder 22 of guide upper wall 114, and specifically, is provided on downstream side in the predetermined feeding direction of carrier tape 80 from a peeling position where peeling member 166 peels off cover tape 83. Upper surface support portion 117 continuously extends along feeding direction A, and is formed in a band shape. Upper surface support portion 117 may be formed integrally with peeling member 166. Upper surface support portion 117 is a section for supporting the upper surface of carrier tape 80 during conveyance by restricting the upward movement of carrier tape 80 by coming into contact with the upper surface of carrier tape 80 on tape conveyance path 111.

Before carrier tape 80 enters between tape guide 110 and tape conveyance path 111, upper surface support portion 117 is brought into contact with tape conveyance path 111 by the biasing force of the biasing member. When carrier tape 80 enters between the tip portion of tape guide 110 and tape conveyance path 111 in this state, the tip portion of tape guide 110 is pressed up against the biasing force of the biasing member by carrier tape 80, and upper surface support portion 117 is separated upward from tape conveyance path 111.

At this time, upper surface support portion 117 pinches carrier tape 80 with tape conveyance path 111 by coming into contact with the upper surface of carrier tape 80. Separation distance Ta between the lower surface of upper surface support portion 117 and the upper surface of tape conveyance path 111 in a state where carrier tape 80 is pinched therebetween coincides with a vertical thicknesses of carrier tape 80 (specifically, a thickness of carrier tape 80 in a state where cover tape 83 is peeled off from base tape 81 (that is, a thickness obtained by adding a thickness of base tape 81 and a thickness of bottom tape 82 to each other)).

A part on the upstream side in the predetermined feeding direction of carrier tape 80 from the peeling position in guide upper wall 114 may be separated to exceed separation distance Ta from the upper surface of tape conveyance path 111 in a state where carrier tape 80 is pinched between tape conveyance path 111 and upper surface support portion 117. A separation distance exceeding separation distance Ta in guide upper wall 114 may substantially coincide with the thickness of carrier tape 80 in a state where cover tape adheres to base tape 81, or may be larger than the thickness.

Peeling member 166 of tape peeling device 165 is provided to be separated upward from tape conveyance path 111. Peeling member 166 is formed to enter the inside of tape guide 110 (specifically, downward from guide upper wall 114) from an opening provided in guide upper wall 114. Peeling member 166 has a function of peeling cover tape 83 from base tape 81 of carrier tape 80. Before carrier tape 80 enters between tape guide 110 and tape conveyance path 111, even when upper surface support portion 117 is in contact with tape conveyance path 111, peeling member 166 is separated upward from tape conveyance path 111 without coming into contact with tape conveyance path 111, and is further separated upward from tape conveyance path 111 after carrier tape 80 enters between tape guide 110 and tape conveyance path 111.

The lower surface of upper surface support portion 117 is located below a lower surface (bottom surface) of at least the tip portion (that is, a rear side end part based on feeder main body 100) of peeling member 166. That is, tape guide 110 is formed so that the bottom surface of the tip portion of peeling member 166 is positioned above the lower surface of upper surface support portion 117 with respect to tape conveyance path 111. Separation distance Tb between the lower surface of the tip portion of peeling member 166 and upper surface of the tape conveyance path 111 in a state where carrier tape 80 is pinched between tape guide 110 and tape conveyance path 111 is larger than the thickness of carrier tape 80 in a state where cover tape 83 is peeled off from base tape 81 (that is, the thickness obtained by adding the thickness of base tape 81 and the thickness of bottom tape 82 to each other).

Guide upper wall 114 further has a component passage portion 118. Component passage portion 118 is a portion (may include a portion other than the tip portion in peeling member 166) provided on the downstream side in the predetermined feeding direction of carrier tape 80 from the tip portion (that is, the above-described peeling position) of peeling member 166, and is a portion in which not only accommodation hole 81a of base tape 81 but also component 60 accommodated in accommodation hole 81a passes below during the conveyance of carrier tape 80. Component passage portion 118 extends in feeding direction A, and is formed in a band shape to have a width larger than a width of accommodation hole 81a. Component passage portion 118 may be formed integrally with peeling member 166 or upper surface support portion 117.

Component passage portion 118 is separated upward from tape conveyance path 111 during the conveyance of carrier tape 80. Component passage portion 118 is not a supporting section which comes into contact with the upper surface of carrier tape 80 from which cover tape 83 is peeled off during the conveyance, and does not include upper surface support portion 117. The lower surface of component passage portion 118 is located at a height substantially the same as that of the lower surface of the tip portion of peeling member 166 with respect to tape conveyance path 111, and is located above the lower surface of upper surface support portion 117. Separation distance Tc between the lower surface of component passage portion 18 and the upper surface of tape conveyance path 111 in a state where the carrier tape 80 is pinched between tape guide 110 and tape conveyance path 111 is larger than the thickness of carrier tape 80 in a state where cover tape 83 is peeled off from base tape 81 (that is, the thickness obtained by adding the thickness of base tape 81 and the thickness of bottom tape 82 to each other).

That is, separation distance Tb and separation distance Tc substantially coincide with each other (Tb ≒ Tc). In addition, separation distances Tb and Tc are large than separation distance Ta (Tb (≒ Tc) > Ta). For example, a difference between the separation distances | Tb (≒ Tc)-Ta | may correspond to a maximum value of a protruding amount expected so that component 60 accommodated in accommodation hole 81a during the conveyance of carrier tape 80 protrudes upward from the upper surface of base tape 81, or may be set to be equal to or greater than the maximum value.

Upper surface support portion 117 is provided adjacent to component passage portion 118 in the width direction of carrier tape 80. Upper surface support portion 117 is provided on one side in the width direction of guide upper wall 114 (specifically, a side having accommodation hole 81a which is opposite to a side having engagement hole 81b of carrier tape 80 in the width direction). Upper surface support portion 117 and component passage portion 118 extend parallel to feeding direction A in a state of being adjacent to each other in the width direction. Upper surface support portion 117 continuously extends along feeding direction A of carrier tape 80, and the lower surface is formed to form a plane.

In tape guide 110, peeling member 166 and component passage portion 118 (including a portion excluding the tip portion of peeling member 166) are formed so that the lower surfaces facing tape conveyance path 111 are flush with each other. On the other hand, step portion 119 is formed between the lower surfaces of component passage portion 118 and upper surface support portion 117 which face tape conveyance path 111. A difference in height position between the upper end and the lower end in step portion 119 is generated by difference between the separation distances | Tb (≒ Tc)-Ta |. Step portion 119 extends along feeding direction A of carrier tape 80. Step portion 119 may be formed so that the position of the lower surface is rapidly changed between component passage portion 118 and upper surface support portion 117 or so that the lower surfaces are connected to each other via an orthogonal surface, or may be formed so that the position of the lower surface position is smoothly changed or so that the lower surface are connected to each other via an inclined surface or a curved surface.

In a structure of feeder 22 including tape guide 110, when carrier tape 80 is inserted into tape insertion section 101 of feeder main body 100, sprocket 120 is rotated. In this case, while engagement projection 123 of sprocket 120 engages with engagement hole 81b, carrier tape 80 is fed toward tape discharge section 102 side in feeding direction A in a state of being supported on the lower surface by tape conveyance path 111. When the tip on the downstream side in the predetermined feeding direction of carrier tape 80 reaches tape guide 110 which is biased downward by the biasing member, carrier tape 80 enters the inside of tape guide 110 by pressing up tape guide 110, and carrier tape 80 is guided to guide upper wall 114 by the upper surface and guided to each of guide side walls 112 and 113 by the side surface. Thereafter, carrier tape 80 is fed in feeding direction A in a state where engagement projection 123 of front side sprocket 122 engages with engagement hole 81b.

Next, when the tip on the downstream side in the predetermined feeding direction of carrier tape 80 reaches the tip of peeling member 166 of tape peeling device 165, the cutting edge of the tip of peeling member 166 is inserted between base tape 81 and cover tape 83, one end side of cover tape 83 in the width direction starts to be peeled off from base tape 81. When carrier tape 80 is further progressively fed, as illustrated in Figs. 13, 14, and 15, while being supported on the lower surface by tape conveyance path 111, carrier tape 80 is brought into a state of being in contact with upper surface support portion 117 on the upper surface (specifically, the upper surface of base tape 81). That is, base tape 81 of carrier tape 80 is brought into a state of being pinched between the upper surface of tape conveyance path 111 and the lower surface of upper surface support portion 117. In this case, the upward movement of carrier tape 80 is restricted by upper surface support portion 117, and the upper surface (specifically, a part of the upper surface of base tape 81) of carrier tape 80 is supported.

The tip portion of peeling member 166 is located at a position higher than the height position of the lower surface of upper surface support portion 117, based on the upper surface of tape conveyance path 111. Therefore, in a state where the upper surface of base tape 81 is supported by upper surface support portion 117, a height position of a boundary area between base tape 81 and cover tape 83 at the peeling position of carrier tape 80 is higher than a height position of the upper surface at a support position of carrier tape 80 supported by upper surface support portion 117. According to this structure, a downward pulling force can be applied to base tape 81 from which cover tape 83 is peeled off at the peeling position, on the downstream side (that is, a range from the peeling position to the support position) in the predetermined feeding direction from the peeling position. The applied force corresponds to the difference in the height positions.

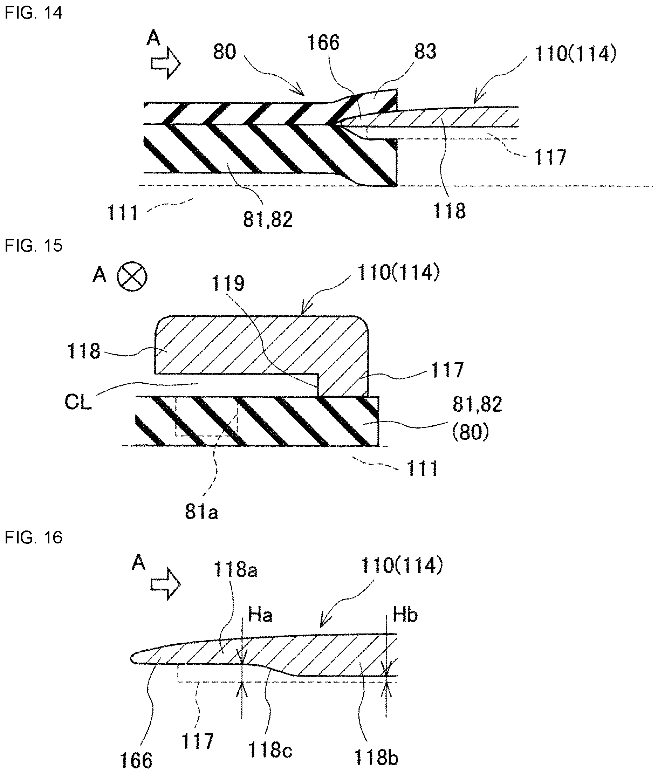

When base tape 81 is pulled downward on the downstream side in the predetermined feeding direction from the peeling position, the height position of the opening of accommodation hole 81a of base tape 81 passes through the peeling position, and thereafter from the height position at the peeling position, gradually moves downward from the peeling position toward the support position of upper surface support portion 117. When the height position of the opening of the accommodation hole 81a is located in the vicinity of the cutting edge of peeling member 166 at the peeling position, and moves downward from immediately after passing through the peeling position, the opening of accommodation hole 81a of base tape 81 is separated downward from the lower surface of peeling member 166 immediately after passing the peeling position. In this structure, compared to a comparison structure in which peeling member 166 and upper surface support portion 117 are located at substantially the same height position in tape guide 110, as illustrated in Fig. 15, and clearance CL is secured between the opening of accommodation hole 81a on the upper surface of base tape 81 and the lower surface of peeling member 166.

Therefore, according to the structure of feeder 22, after cover tape 83 is peeled off from base tape 81, it is possible to avoid a possibility that component 60 exposed inside accommodation hole 81a of base tape 81 may be likely to come into contact with the lower surface of peeling member 166. Therefore, it is possible to prevent component 60 exposed inside base tape 81 after passing through the peeling position from being damaged by peeling member 166.

In addition, component passage portion 118 of tape guide 110 is located at the height position substantially the same as the height position of the tip portion of peeling member 166 based on the upper surface of tape conveyance path 111, and is located at the height position higher than the height position of the lower surface of upper surface support portion 117. Therefore, as illustrated in Fig. 15, in a state where upper surface of carrier tape 80 (specifically, base tape 81) is supported by upper surface support portion 117, clearance CL is secured between the lower surface of component passage portion 118 on the downstream side in the predetermined feeding direction from the peeling position and the upper surface of carrier tape 80.

According to this structure, during the conveyance of carrier tape 80, even when component 60 inside the accommodation hole 81a protrudes upward by the amount of clearance CL from the upper surface of base tape 81 after passing through the peeling position, it is possible to prevent component 60 from coming into contact with the lower surface of guide upper wall 114 (that is, component passage portion 118). Therefore, it is possible to prevent component 60 exposed inside base tape 81 after passing through the peeling position from being damaged by guide upper wall 114 of tape guide 110.

In the above-described embodiment, sprocket 120 corresponds to a "feeding device" disclosed in the appended claims.

### 5. Modification Example

Incidentally, in the above-described embodiment, the entire lower surface of component passage portion 118 of guide upper wall 114 of tape guide 110 is located above the lower surface of upper surface support portion 117, and is located at a height which is substantially the same as that of the tip portion of peeling member 166. However, feeder 22 is not limited thereto.

For example, as illustrated in Fig. 16, component passage portion 118 has first component passage portion 118a and second component passage portion 118b in which the lower surfaces have different height positions. First component passage portion 118a is provided on the upstream side in feeding direction A in a whole area of component passage portion 118, and is a portion continuous with the tip portion of peeling member 166. Second component passage portion 118b is a portion provided on the downstream side in feeding direction A from first component passage portion 118a. The lower surface of first component passage portion 118a is located above the lower surface of upper surface support portion 117, and is located at the height substantially the same as that of the bottom surface of the tip portion of peeling member 166. Second component passage portion 118b is located above the lower surface of upper surface support portion 117, and is located at the height lower than that of the tip portion of peeling member 166. First component passage portion 118a may be a portion positioned on the downstream side in the predetermined feeding direction from the tip portion (that is, the peeling position) of peeling member 166 of the guide upper wall 114 by one pitch to two pitches when a distance between two engagement holes 81b aligned in feeding direction A is set as one pitch.

In the structure according to this modification example, step portion 119 having relatively great height position difference (step) Ha is formed between the lower surfaces of first component passage portion 118a and upper surface support portion 117, and step portion 119 having relatively small height difference Hb is formed between the lower surfaces of second component passage portion 118b and upper surface support portion 117. Immediately after base tape 81 of carrier tape 80 and cover tape 83 are peeled off, component 60 inside accommodation hole 81a of base tape 81 is likely to move upward and downward. In contrast, according to the above-described structure, since step Ha of step portion 119 on the upstream side in feeding direction A is relatively great, it is possible to prevent component 60 from being damaged. In addition, as the position is separated far from peeling position of peeling member 166, component 60 inside accommodation hole 81a of base tape 81 is less likely to move upward and downward, and thus, is brought into a stabilized state. In contrast, according to the above-described structure, since step Hb of step portion 119 on the downstream side in feeding direction A is relatively small, while component 60 is prevented from being damaged, the upward movement can be reliably restricted by minimizing floating of base tape 81.

In addition, in the structure of the above-described modification example, step portion 118c generating a step corresponding to (Ha-Hb) is formed between the lower surfaces of first component passage portion 118a and second component passage portion 118b. As illustrated in Fig. 16, it is preferable that step portion 118c is formed so that the position of the lower surface is smoothly changed or the lower surfaces are connected to each other by an inclined surface or a curved surface. According to the structure of step portion 118c, even when the component inside base tape 81 comes into contact with step portion 118c when passing through step portion 118c, it is possible to avoid a possibility of the contact portion being a surface or a corner portion orthogonal to feeding direction A of step portion 118c, and it is possible to soften the damage to component 60, which is caused by the shape of step portion 118c, compared to a structure in which the step portion is formed so that the position of the lower surface is rapidly changed or so that the lower surfaces are connected to each other via an orthogonal surface.

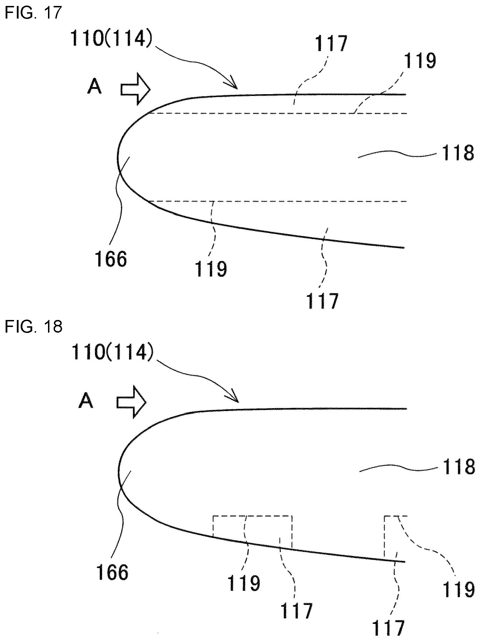

In addition, in the above-described embodiment, upper surface support portion 117 of tape guide 110 is provided adjacent only to one side in the width direction of carrier tape 80 with respect to component passage portion 118. However, upper surface support portion 117 is not limited to a case of being provided only on one side in the width direction of carrier tape 80, and as illustrated in Fig. 17, upper surface support portion 117 may be provided separately corresponding to each of both sides in the width direction of carrier tape 80. However, upper surface support portion 117 can reliably restrict the upward movement of carrier tape 80 during the conveyance in the structure in which upper surface support portions 117 are respectively provided on both sides in the width direction across component passage portion 118, compared to the structure in which upper surface support portion 117 is provided only on one side in the width direction of carrier tape 80, and it is preferable since carrier tape 80 can be reliably supported.

In addition, in this modification example, upper surface support portions 117 respectively provided on both sides in the width direction across component passage portion 118 may be separately formed as tape guide 110, but may be formed integrally with each other as tape guide 110. When upper surface support portions 117 on both sides in the width direction across component passage portion 118 are formed integrally with each other, carrier tape 80 during the conveyance can be reliably supported by upper surface support portion 117 without increasing the number of components.

In addition, in the above-described embodiment, upper surface support portion 117 continuously extends along feeding direction A of carrier tape 80, and the lower surface is formed to form one plane. However, as illustrated in Fig. 18, upper surface support portion 117 may be intermittently provided along feeding direction A of carrier tape 80, that is, may be provided in a scattered shape along feeding direction A of carrier tape 80. In this structure, since carrier tape 80 can be supported at multiple locations in feeding direction A where upper surface support portions 117 are scattered, resistance received from upper surface support portion 117 by carrier tape 80 during the conveyance can be reduced, and clogging during the conveyance can be suppressed by smoothly conveying carrier tape 80.

Furthermore, in the above-described embodiment, carrier tape 80 has a structure in which bottom tape 82 adheres to the lower surface of base tape 81 provided with accommodation hole 81a penetrating therethrough. However, carrier tape 80 is not limited thereto, and may be an embossed carrier tape having a base tape provided with a groove for accommodating component 60 without causing bottom tape 82 to adhere to the lower surface.

Feeder 22 is not limited to the above-described embodiment or the modification example, and various modifications can be made within the scope of the appended claims.

### Reference Signs List

1: component mounter, 21: slot, 22: feeder, 50: board, 60: component, 80: carrier tape, 81: base tape, 81a: accommodation hole, 81b: engagement hole, 83: cover tape, 100: feeder main body, 110: tape guide, 111: tape conveyance path, 112, 113: guide side wall, 114: guide upper wall, 116: component fetching section, 117: upper surface support portion, 118: component passage portion, 118a: first component passage portion, 118b: second component passage portion, 119: step portion, 120: sprocket, 165: tape peeling device, 166: peeling member.

## Claims

1. A feeder (22) for supplying a component (60) to a predetermined supply position by feeding a carrier tape (80) accommodating the component (60) in a predetermined feeding direction,
the carrier tape (80) having a base tape (81) provided with an accommodation section (81a) for accommodating the component (60), and a cover tape (83) attached to an upper surface of the base tape (81) to close the accommodation section (81a),
wherein the feeder (22) further comprises:
a tape conveyance path (111) extending along the predetermined feeding direction to support a lower surface of the carrier tape (80);
a feeding device (120) configured to feed the carrier tape (80) on the tape conveyance path (111); and
a tape guide (110) provided above the tape conveyance path (111) to guide the carrier tape (80) on the tape conveyance path (111), and
wherein the tape guide (110) has:
a peeling member (166) configured to peel off the cover tape (83) from the base tape (81) of the carrier tape (80) on the tape conveyance path (111), and
an upper surface support portion (117), being provided on a downstream side of a tip portion of the peeling member (166) in the predetermined feeding direction, which is configured to restrict an upward movement of the base tape (81), from which the cover tape (83) is peeled off, by coming into contact with the upper surface of the base tape (81), and which has a lower surface positioned below a bottom surface of the tip portion of the peeling member (166),
**characterized in that**
the tape guide (110) has a step portion (119) formed between the bottom surface of the tip portion of the peeling member (166) and the lower surface of the upper surface support portion (117).

2. The feeder according to Claim 1,
wherein the tape guide (110) has a component passage portion (118) provided on the downstream side of the tip portion of the peeling member (166) in the predetermined feeding direction, and which is configured such that the component (60) accommodated in the accommodation section (81a) passes under the component passage portion (118) during conveyance of the carrier tape (80), the component passage portion (118) having a lower surface positioned above the lower surface of upper surface support portion (117).

3. The feeder according to Claim 2,
wherein the component passage portion (118) has
a first component passage portion (118a), a lower surface which being positioned at a height the same as that of the bottom surface of the tip portion of the peeling member (166), and
a second component passage portion (118b) provided on the downstream side of the first component passage portion (118a) in the predetermined feeding direction, a lower surface of which being positioned below the bottom surface of the tip portion of the peeling member (166).

4. The feeder according to Claim 2 or 3,
wherein the upper surface support portion (117) has a first upper surface support portion and a second upper surface support portion which are provided on both sides in a width direction orthogonal to the predetermined feeding direction with the component passage portion (118) interposed therebetween.

5. The feeder according to Claim 4,
wherein the first upper surface support portion and the second upper surface support portion are integrally formed with each other.

6. The feeder according to any one of Claims 1 to 5,
wherein the upper surface support portion (117) continuously extends along the predetermined feeding direction.

7. The feeder according to any one of Claims 1 to 5,
wherein the upper surface support portion (117) is intermittently provided along the predetermined feeding direction.

## Patentansprüche

1. Transportvorrichtung (22) zum Zuführen eines Bauteils (60) zu einer vorgegebenen Zuführposition durch Transportieren eines Trägerbandes (80), das das Bauteil (60) aufnimmt, in einer vorgegebenen Transportrichtung,
wobei das Trägerband (80) ein Basisband (81), das mit einem Aufnahmeabschnitt (81a) zum Aufnehmen des Bauteils (60) versehen ist, und ein Abdeckband (83) aufweist, das an einer Oberseite des Basisbandes (81) angebracht ist, um den Aufnahmeabschnitt (81a) zu verschließen,
wobei die Transportvorrichtung (22) des Weiteren umfasst:
einen Band-Förderweg (111), der sich entlang der vorgegebenen Transportrichtung erstreckt und eine Unterseite des Trägerbandes (80) trägt;
eine Transporteinrichtung (120), die so ausgeführt ist, dass sie das Trägerband (80) auf dem Band-Förderweg (111) transportiert;
sowie
eine Bandführung (110), die sich oberhalb des Band-Förderweges (111) befindet und das Trägerband (80) auf dem Band-Förderweg (111) führt, und
wobei die Bandführung (110) aufweist:
ein Abziehelement (166), das so ausgeführt ist, dass es das Abdeckband (83) von dem Basisband (81) des Trägerbandes (80) auf dem Bandtransportweg (111) abzieht, und
einen Oberseiten-Trageabschnitt (117), der sich an einer stromab liegenden Seite eines vorderen Abschnitts des Abziehelementes (166) in der vorgegebenen Transportrichtung befindet, der so eingerichtet ist, dass er eine Aufwärtsbewegung des Basisbandes (81), von dem das Abdeckband (83) abgezogen wird, dadurch einschränkt, dass er mit der Oberseite des Basisbandes (81) in Kontakt kommt, und der eine untere Fläche hat, die unterhalb einer Unterseite des vorderen Abschnitts des Abziehelementes (166) positioniert ist,
**dadurch gekennzeichnet, dass**
die Bandführung (110) einen Absatzabschnitt (119) aufweist, der zwischen der Unterseite des vorderen Abschnitts des Abziehelementes (166) und der unteren Fläche des Oberseiten-Trageabschnitts (117) ausgebildet ist.

2. Transportvorrichtung nach Anspruch 1,
wobei die Bandführung (110) einen Bauteil-Durchlaufabschnitt (118) aufweist, der an der stromab liegenden Seite des vorderen Abschnitts des Abziehelementes (166) in der vorgegebenen Transportrichtung vorhanden ist, und der so ausgeführt ist, dass das in dem Aufnahmeabschnitt (81a) aufgenommene Bauteil (60) beim Fördern des Trägerbandes (80) unter dem Bauteil-Durchlaufabschnitt (118) durchläuft, wobei der Bauteil-Durchlaufabschnitt (118) eine untere Fläche aufweist, die oberhalb der unteren Fläche des Oberseiten-Trageabschnitts (117) angeordnet ist.

3. Transportvorrichtung nach Anspruch 2,
wobei der Bauteil-Durchlaufabschnitt (118) aufweist:
einen ersten Bauteil-Durchlaufabschnitt (118a), dessen Unterseite in einer Höhe angeordnet ist, die die gleiche ist wie die der Unterseite des vorderen Abschnitts des Abziehelementes (166), sowie
einen zweiten Bauteil-Durchlaufabschnitt (118b), der an der stromab liegenden Seite des ersten Bauteil-Durchlaufabschnitts (118a) in der vorgegebenen Transportrichtung vorhanden ist, wobei eine untere Fläche desselben unterhalb der Unterseite des vorderen Abschnitts des Abziehelementes (166) angeordnet ist.

4. Transportvorrichtung nach Anspruch 2 oder 3,
wobei der Oberseiten-Trageabschnitt (117) einen ersten Oberseiten-Trageabschnitt und einen zweiten Oberseiten-Trageabschnitt aufweist, die an beiden Seiten in einer Breitenrichtung senkrecht zu der vorgegebenen Transportrichtung vorhanden sind, wobei der Bauteil-Durchlaufabschnitt (118) zwischen ihnen angeordnet ist.

5. Transportvorrichtung nach Anspruch 4,
wobei der erste obere Oberseiten-Trageabschnitt und der zweite Oberseiten-Trageabschnitt integral miteinander ausgebildet sind.

6. Transportvorrichtung nach einem der Ansprüche 1 bis 5,
wobei sich der Oberseiten-Trageabschnitt (117) durchgehend entlang der vorgegebenen Transportrichtung erstreckt.

7. Transportvorrichtung nach einem der Ansprüche 1 bis 5,
wobei der Oberseiten-Trageabschnitt (117) intermittierend entlang der vorgegebenen Transportrichtung vorhanden ist.

## Revendications

1. Dispositif d'alimentation (22) destiné à alimenter un composant (60) à une position d'alimentation prédéterminée en alimentant une bande de transport (80) sur laquelle est logé le composant (60) dans une direction d'alimentation prédéterminée,
la bande de transport (80) comportant une bande de base (81) pourvue d'une section de logement (81a) pour loger le composant (60), et une bande de recouvrement (83) attachée à une surface supérieure de la bande de base (81) pour fermer la section de logement (81a),
dans lequel le dispositif d'alimentation (22) comprend en outre :
une voie de convoyage de bande (111) qui s'étend selon la direction d'alimentation prédéterminée pour supporter une surface inférieure de la bande de transport (80) ;
un dispositif d'alimentation (120) configuré pour alimenter la bande de transport (80) sur la voie de convoyage de bande (111) ; et
un guide-bande (110) pourvu au-dessus de la voie de convoyage de bande (111) pour guider la bande de transport (80) sur la voie de convoyage de bande (111), et
dans lequel le guide-bande (110) comporte :
un élément de pelage (166) configuré pour peler la bande de recouvrement (83) de la bande de base (81) de la bande de transport (80) sur la voie de convoyage de bande (111), et
une portion de support de surface supérieure (117) pourvue sur un côté aval d'une portion d'embout de l'élément de pelage (166) dans la direction d'alimentation prédéterminée, qui est configurée pour limiter un mouvement vers le haut de la bande de base (81), dont le bande de recouvrement (83) est pelée, en venant en contact avec la surface supérieure du ruban de base (81), et qui présente une surface inférieure positionnée au-dessous d'une surface de fond de la portion d'embout de l'élément de pelage (166),
**caractérisé en ce que** le guide-bande (110) comporte une portion d'échelon (119) formée entre la surface de fond de la portion d'embout de l'élément de pelage (166) et la surface inférieure de la portion de support de surface supérieure (117).

2. Dispositif d'alimentation selon la revendication 1,
dans lequel le guide-bande (110) comporte une portion de passage de composant (118) pourvue du côté aval de la portion d'embout de l'élément de pelage (166) dans la direction d'alimentation prédéterminée, et configurée de telle sorte que le composant (60) logé dans la section de logement (81a) passe sous la portion de passage de composant (118) pendant le transport de la bande de transport (80), la portion de passage de composant (118) présentant une surface inférieure positionnée au-dessus de la surface inférieure de la portion de support de surface supérieure (117).

3. Dispositif d'alimentation selon la revendication 2, dans lequel la portion de passage de composant (118) comporte
une première portion de passage de composant (118a), dont une surface inférieure est positionnée à une hauteur identique à celle de la surface de fond de la portion d'embout de l'élément de pelage (166), et
une deuxième portion de passage de composant (118b) pourvue du côté aval de la première portion de passage de composant (118a) dans la direction d'alimentation prédéterminée, dont une surface inférieure est positionnée au-dessous de la surface de fond de la portion d'embout de l'élément de pelage (166).

4. Dispositif d'alimentation selon la revendication 2 ou 3,
dans lequel la portion de support de surface supérieure (117) comporte une première portion de support de surface supérieure et une deuxième portion de support de surface supérieure, qui sont pourvues des deux côtés dans une direction de la largeur orthogonale à la direction d'alimentation prédéterminée, et entre lesquelles est interposée la portion de passage de composant (118).

5. Dispositif d'alimentation selon la revendication 4,
dans lequel la première portion de support de surface supérieure et la deuxième portion de support de surface supérieure sont formées conjointement de manière intégrée.

6. Dispositif d'alimentation selon l'une quelconque des revendications 1 à 5,
dans lequel la portion de support de surface supérieure (117) s'étend en continu selon la direction d'alimentation prédéterminée.

7. Dispositif d'alimentation selon l'une quelconque des revendications 1 à 5,
dans lequel la portion de support de surface supérieure (117) est pourvue de manière intermittente selon la direction d'alimentation prédéterminée.
